# EUROPEAN PATENT APPLICATION

(11) **EP 4 841 613 A1**
(43) Date of publication of application: **18.11.2026**
(21) Application number: 25179011.9
(22) Date of filing: 27.05.2025
(51) Int. Cl.: G09F 9/302, G09F 9/33, G09F 15/00

(54) **FRAME SPACER SUITABLE FOR DISPLAY FRAMES**

(30) Priority: 16.05.2025 CN 202510631733
(71) Applicant: Staqon Limited, Span Po Kong KLN (HK)
(72) Inventor: XU, Shengmu, San Po Kong KLN (HK)
(74) Representative: Tahtadjiev, Konstantin

(57) **Abstract**

The present invention relates to a frame spacer suitable for display frames, which has a spacer thickness, and N of the frame spacers are detachably connected to a first display body with a first width and a first height, when N of the frame spacers are positioned transversely on the first display body, a transverse width of the first display body is the sum of the first width and N times the spacer thickness, when N of the frame spacers are positioned longitudinally on the first display body, a longitudinal height of the first display body is the sum of the first height and N times the spacer thickness, a second display body has a second width and a second height, the second width is equal to the transverse width of the first display body, and the second height is equal to the longitudinal height of the first display body.

## Description

### FIELD OF THE INVENTION

The present invention relates to a spacer structure, and more particularly to a detachable frame spacer mounted on a first display body, enabling the first display body and a second display body to have identical external dimensions, wherein the first display body is a display frame or an integrated LED display panel, and the second display body is a display frame or an integrated LED display panel.

### PRIOR ART

LED display screens have been widely used in various exhibition applications such as in showrooms and at trade shows due to their excellent performance.

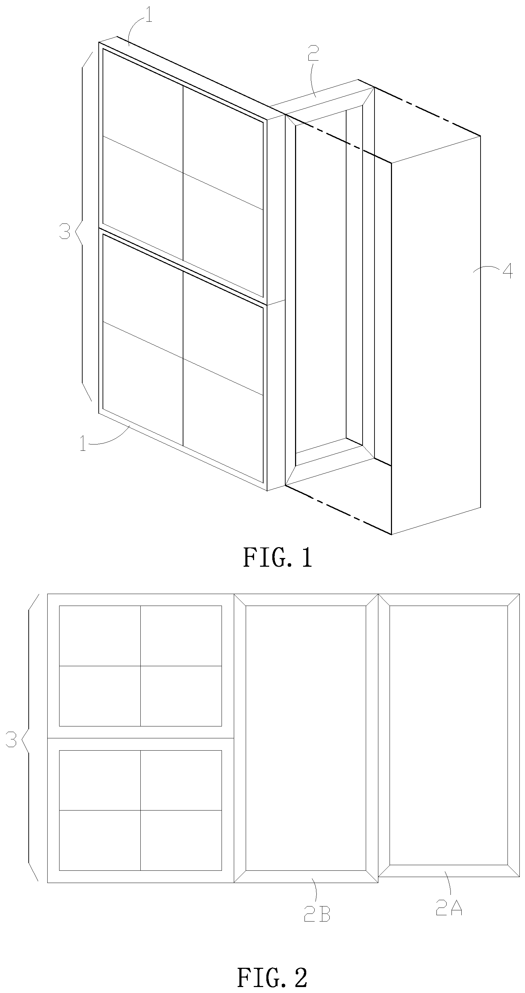

As shown in FIG. 1, in current exhibition scenarios, an LED display platform typically consists of two components: an LED display panel (1) and a display frame (2), wherein multiple LED display panels (1) are assembled to form an integrated LED display (3), while the display frame (2) is mounted on one side of the integrated LED display (3). During operation, the integrated LED display (3) is powered to exhibit dynamic promotional images, while an advertising cloth mounted on the display frame presents static display information.

The advantages of the LED display platform are as follows:
Firstly, the LED display platform includes an image display portion and an advertising cloth display portion, wherein the image display portion is formed by the integrated LED display (3) which is powered to emit light for displaying promotional image information externally, and the advertising cloth display portion is formed by an advertising cloth (4) mounted on the display frame (2) for externally displaying static presentation information. The overall display approach is diversified, significantly enhancing the display effects.

Moreover, since the display frame (2) combined with the advertising cloth (4) also serves a display function, the display frame (2) can partially replace the display function of the integrated LED display (3). However, as the manufacturing cost of the display frame (2) is relatively low, utilizing the structure of the display frame (2) can greatly reduce the cost of a traditional LED display platform, thereby significantly lowering the overall exhibition cost.

The use of the display frame (2) provides numerous conveniences for exhibition layout, while also enhancing the display effect and reducing display costs. However, in practical use, the above-mentioned display frame (2) still has various drawbacks, which are described as follows.

As shown in FIG. 2, in practice, the display frame (2) generally comes in multiple size specifications, such as a display frame (2A) with dimensions of 486mm*992mm, and a display frame (2B) with dimensions of 500mm*1000mm. Due to the different outer dimensions of the display frame (2A) and the display frame (2B), there will be a mismatch in dimensions between the display frames during assembly, resulting in compatibility issues. This is the major drawback of traditional display frames.

### SUMMARY OF THE INVENTION

The objective of the present invention is to provide a frame spacer (100) suitable for display frames, wherein the frame spacer (100) has a spacer thickness dimension (T), and N of the frame spacers (100) are detachably connected to a first display body (10), where N is greater than or equal to 1.

The first display body (10) has a first width dimension (W1) and a first height dimension (H1).

When N of the frame spacers (100) are disposed at the transverse position of the first display body (10), a transverse width dimension (WB1) of the first display body (10) is equal to the sum of the first width dimension (W1) and N times the spacer thickness dimension (T).

When N of the frame spacers (100) are disposed at the longitudinal position of the first display body (10), a longitudinal height dimension (HB1) of the first display body (10) is equal to the sum of the first height dimension (H1) and N times the spacer thickness dimension (T).

When N1 of the frame spacers (100) are disposed at the transverse position and N2 of the frame spacers (100) are disposed at the longitudinal position of the first display body (10), the transverse width dimension (WB1) of the first display body (10) is the sum of the first width dimension (W1) and N1 times the spacer thickness dimension (T), and the longitudinal height dimension (HB1) of the first display body (10) is the sum of the first height dimension (H1) and N2 times the spacer thickness dimension (T), wherein, the sum of N1 and N2 is equal to N.

A second display body (20) has a second width dimension (W2) and a second height dimension (H2).

When the second display body (20) is assembled together with the first display body (10), the second width dimension (W2) is equal to the transverse width dimension (WB1) of the first display body (10), and the second height dimension (H2) is equal to the longitudinal height dimension (HB1) of the first display body (10).

The first display body (10) is a display frame (30) or an integrated LED display panel (40), and the second display body (20) is the display frame (30) or the integrated LED display panel (40), wherein an advertising cloth (31) is disposed on the display frame (30) to display advertising information, and the integrated LED display panel (40) is used to display image information.

The advantageous effect of the present invention is as follows:
The design concept of the present invention is to dispose N of the frame spacers (100) between the first display body (10) and the second display body (20), such that the first display body (10) and the second display body (20) have identical external dimensions, thereby achieving the objective of assembling the first display body (10) and the second display body (20), which have different external dimensions, together.

### BRIEF DESCRIPTION OF THE DRAWINGS

FIG. 1 is a perspective schematic view of a conventional LED display platform.
FIG. 2 is a front view of a conventional LED display platform.
FIG. 3 is a positional schematic view of the frame spacer of the present invention.
FIG. 4 is another positional schematic view of the frame spacer of the present invention.
FIG. 5 is a schematic view of the assembly of the first display body and the second display body of the present invention.
FIG. 6 is a schematic view of an embodiment in which the first display body is a display frame and the second display body is an integrated LED display panel.
FIG. 7 is a schematic view of an embodiment in which the first display body is an integrated LED display panel and the second display body is a display frame.
FIG. 8 is a schematic view of an advertising cloth disposed on the display frame of the present invention.
FIG. 9 is a schematic view of the present invention illustrating the frame spacer detachably connected to the first display body via a frame connection structure.
FIG. 10 is a schematic view of the present invention illustrating the first display body and the second display body assembled together via the frame connection structure of the frame spacer.
FIG. 11 is a schematic view of the present invention illustrating the frame spacer detachably connected to the first display body and simultaneously used to assemble the first display body and the second display body via the frame connection structure.
FIG. 12 is a schematic view of the present invention illustrating a mounting bolt passing through spacer fixing holes of the frame spacer between a first frame beam and a second frame beam of the present invention.
FIG. 13 is a positional schematic view of the frame spacer of the present invention.
FIG. 14 is a schematic view of the present invention illustrating the frame spacers stacked together.
FIG. 15 is a perspective schematic view of a first embodiment of the frame spacer of the present invention.
FIG. 16 is another perspective schematic view of the first embodiment of the frame spacer of the present invention.
FIG. 17 is a schematic view of the present invention illustrating a protruding portion of the frame spacer inserted into a first display body mounting hole or a second display body mounting hole.
FIG. 18 is a schematic view of a magnet of the present invention.
FIG. 19 is a schematic view of another embodiment of the magnet of the present invention.
FIG. 20 is a perspective schematic view of a second embodiment of the frame spacer of the present invention.
FIG. 21 is another perspective schematic view of the second embodiment of the frame spacer of the present invention.
FIG. 22 is a perspective schematic view of a third embodiment of the frame spacer of the present invention.
FIG. 23 is another perspective schematic view of the third embodiment of the frame spacer of the present invention.
FIG. 24 is a perspective schematic view of a fourth embodiment of the frame spacer of the present invention.
FIG. 25 is another perspective schematic view of the fourth embodiment of the frame spacer of the present invention.

### DETAILED DESCRIPTION OF THE INVENTION

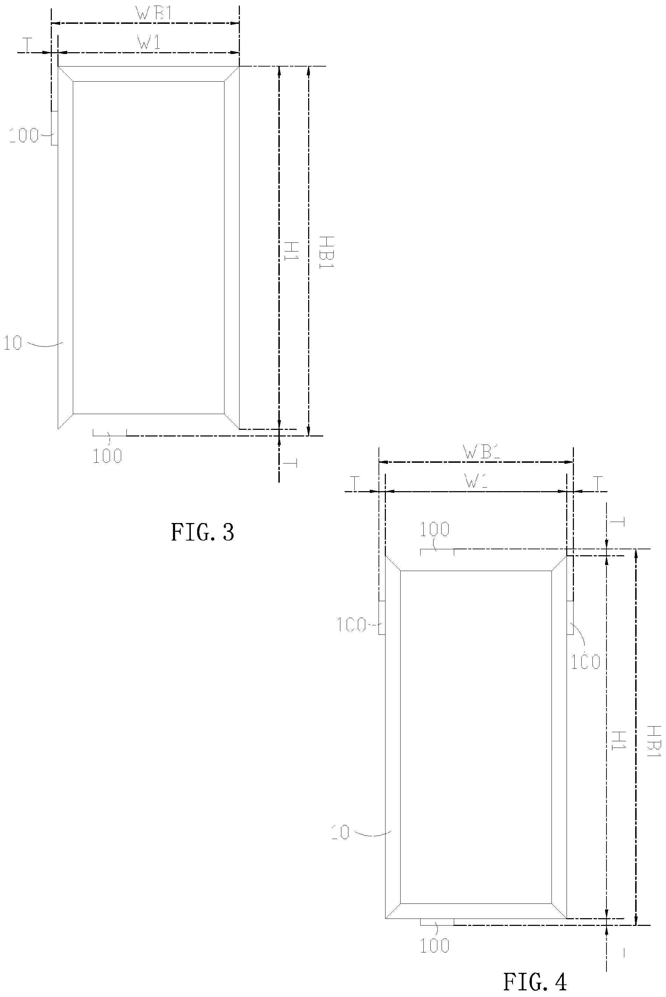

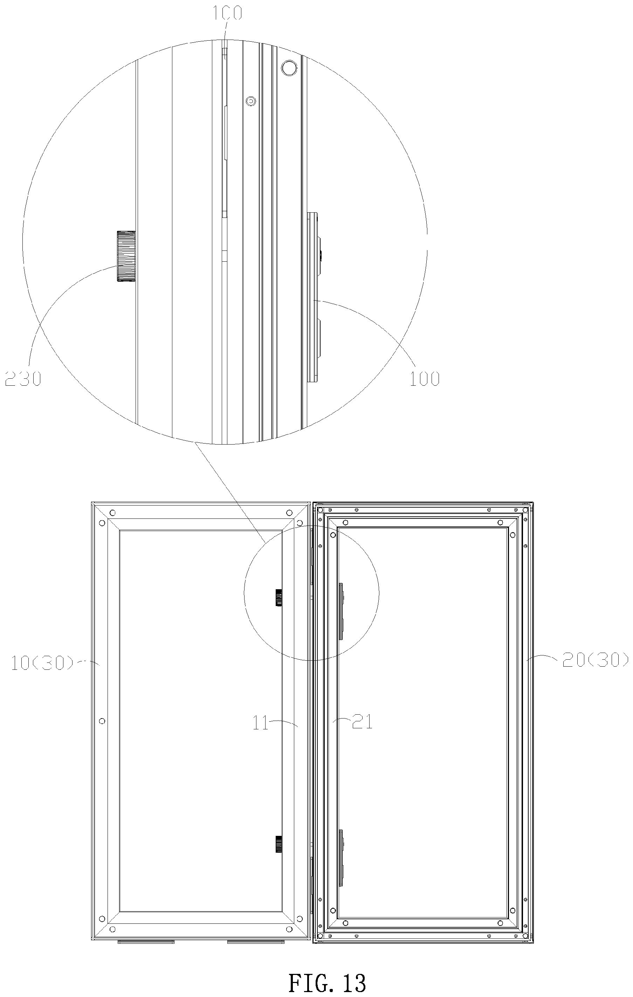

As shown in FIGs. 3 to 25, a frame spacer (100) suitable for display frames is provided. The frame spacer (100) has a spacer thickness dimension (T), and N of the frame spacers (100) are detachably connected to a first display body (10), where N is greater than or equal to 1.

The first display body (10) has a first width dimension (W1) and a first height dimension (H1).

As shown in FIGs. 3 and 4, when N of the frame spacers (100) are disposed at the transverse position of the first display body (10), a transverse width dimension (WB1) of the first display body (10) is equal to the sum of the first width dimension (W1) and N times the spacer thickness dimension (T), that is, WB1 = W1 + N*T.

When N of the frame spacers (100) are disposed at the longitudinal position of the first display body (10), a longitudinal height dimension (HB1) of the first display body (10) is equal to the sum of the first height dimension (H1) and N times the spacer thickness dimension (T), that is, HB1 = H1 + N*T.

When N1 of the frame spacers (100) are disposed at the transverse position and N2 of the frame spacers (100) are disposed at the longitudinal position of the first display body (10), the transverse width dimension (WB1) of the first display body (10) is the sum of the first width dimension (W1) and N1 times the spacer thickness dimension (T), that is, WB1 = W1 + N1*T, and the longitudinal height dimension (HB1) of the first display body (10) is the sum of the first height dimension (H1) and N2 times the spacer thickness dimension (T), that is, HB1 = H1 + N2*T, wherein, the sum of N1 and N2 is equal to N, that is, N1 + N2 = N.

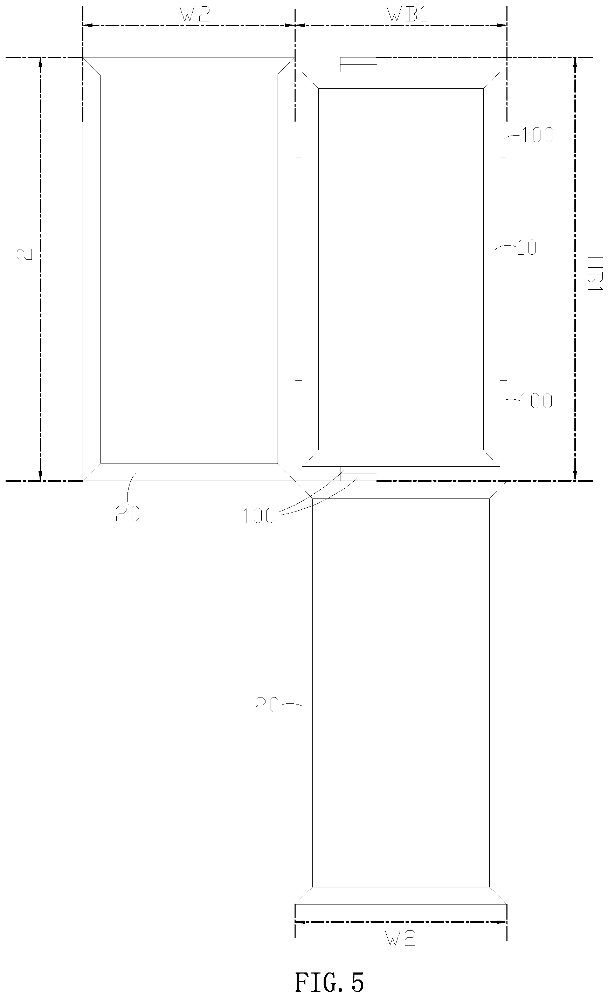

As shown in FIG. 5, a second display body (20) has a second width dimension (W2) and a second height dimension (H2).

When the second display body (20) is assembled together with the first display body (10), the second width dimension (W2) is equal to the transverse width dimension (WB1) of the first display body (10), and the second height dimension (H2) is equal to the longitudinal height dimension (HB1) of the first display body (10).

In other words, the design concept of the present invention is to dispose N the frame spacers (100) between the first display body (10) and the second display body (20), such that the first display body (10) and the second display body (20) have identical external dimensions, thereby achieving the objective of assembling the first display body (10) and the second display body (20), which have different external dimensions, together.

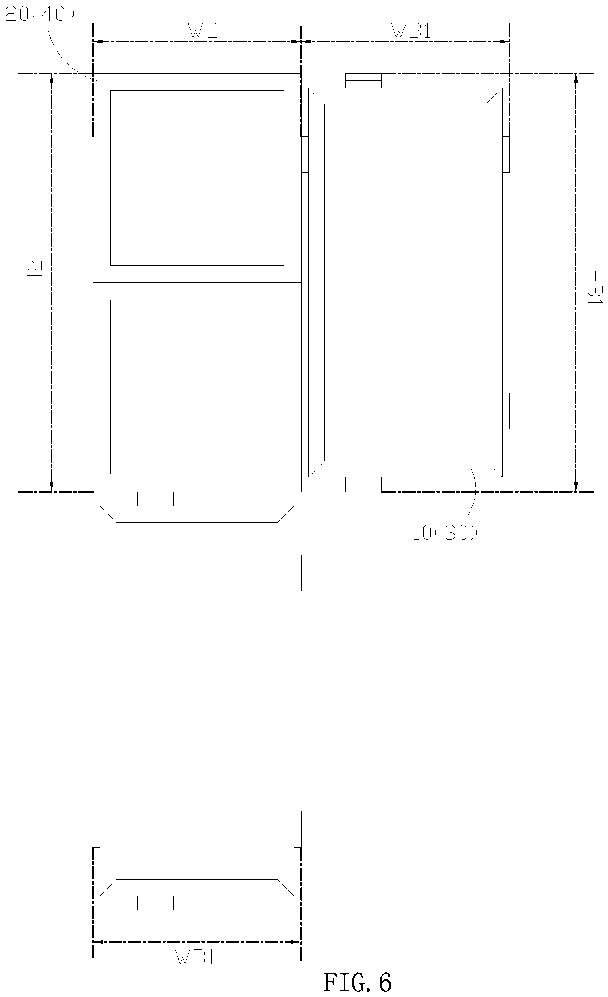

As shown in FIGs. 6 to 8, the first display body (10) is a display frame (30) or an integrated LED display panel (40), and the second display body (20) is the display frame (30) or the integrated LED display panel (40), wherein an advertising cloth (31) is disposed on the display frame (30) to display advertising information, and the integrated LED display panel (40) is used to display image information.

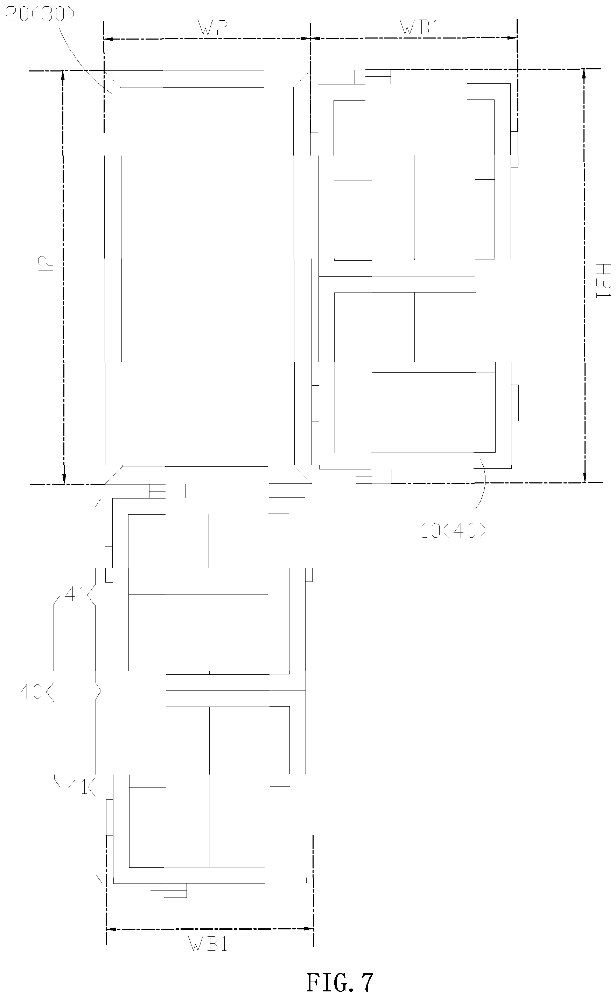

As shown in FIG. 7, in a specific implementation, the integrated LED display panel (40) is formed by assembling multiple LED display panels (41) together.

In a specific implementation, the first width dimension (W1) is not equal to the second width dimension (W2), or the first height dimension (H1) is not equal to the second height dimension (H2), or the first width dimension (W1) is not equal to the second width dimension (W2) and the first height dimension (H1) is not equal to the second height dimension (H2).

In a specific implementation, the first width dimension (W1) is 486 mm, the first height dimension (H1) is 992 mm, the second width dimension (W2) is 500 mm, the second height dimension (H2) is 1000 mm, and the spacer thickness dimension (T) is 4 mm or 8 mm.

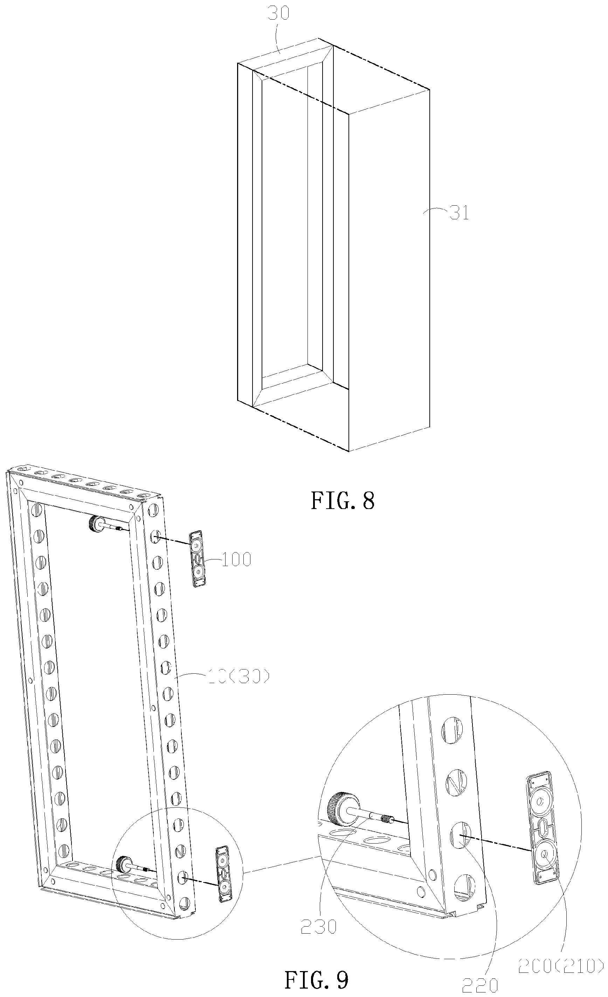

As shown in FIGs. 9 to 12, in a specific implementation, the frame spacer (100) is provided with a frame connection structure (200).

As shown in FIG. 9, through the frame connection structure (200), the frame spacer (100) can be detachably connected to the first display body (10).

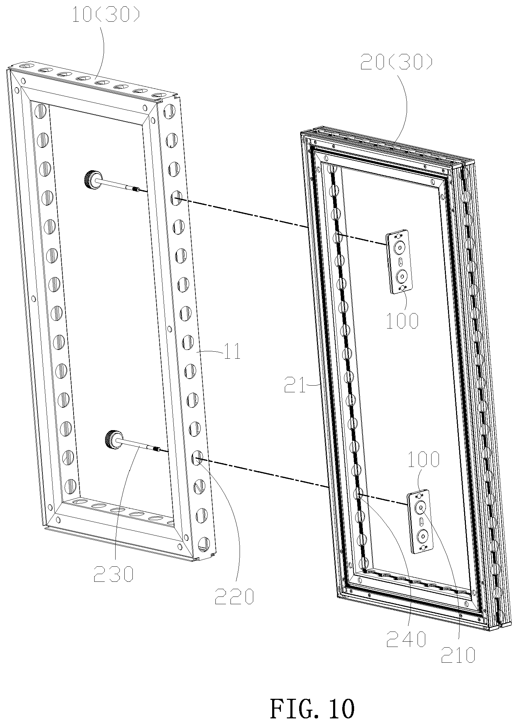

As shown in FIG. 10, through the frame connection structure (200), the first display body (10) and the second display body (20) can be assembled together via the frame spacer (100).

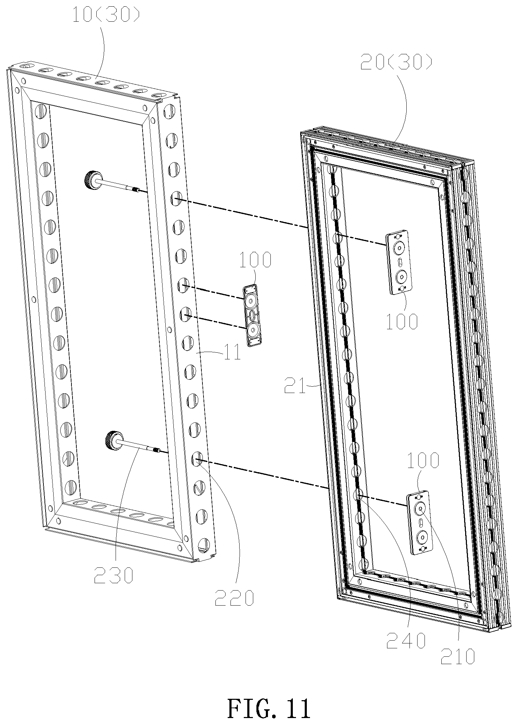

As shown in FIGs. 11 to 13, through the frame connection structure (200), the frame spacer (100) can be detachably connected to the first display body (10), and simultaneously, through the frame connection structure (200), the first display body (10) and the second display body (20) can be assembled together via the frame spacer (100).

In practice, various structures may be adopted to implement the function of the frame connection structure (200). A preferred embodiment is described below.

The frame connection structure (200) comprises spacer fixing holes (210) and mounting bolts (230), wherein the spacer fixing holes (210) are formed on the frame spacer (100). Corresponding to the spacer fixing holes (210), a plurality of first display body mounting holes (220) are provided around the first display body (10). Corresponding to the spacer fixing holes (210), a plurality of second display body mounting holes (240) are provided around the second display body (20).

The first display body (10) comprises a first frame beam (11), and the second display body (20) comprises a second frame beam (21), wherein the first display body mounting holes (220) are formed on the first frame beam (11), and the second display body mounting holes (240) are formed on the second frame beam (21).

As shown in FIG. 9, when the frame spacer (100) is detachably connected to the first display body (10) through the frame connection structure (200), the mounting bolt (230) passes through the spacer fixing hole (210) and the first display body mounting hole (220), the frame spacer (100) is detachably fixed to the first display body (10) by the mounting bolt (230).

As shown in FIG. 10, when the first display body (10) and the second display body (20) are assembled together through the frame connection structure (200) by using the frame spacer (100), the mounting bolt (230) simultaneously passes through the first display body mounting hole (220), the second display body mounting hole (240), and the spacer fixing hole (210), such that the first frame beam (11) and the second frame beam (21) are clamped between the mounting bolt (230) and the frame spacer

(100). Through the above connection relationship, the mounting bolt (230) and the frame spacer (100) can detachably assemble the first display body (10) and the second display body (20) together.

As shown in FIGs. 11 to 13, when the frame spacer (100) is detachably connected to the first display body (10) through the frame connection structure (200), and simultaneously, when the first display body (10) and the second display body (20) are assembled together through the frame connection structure (200) by using the frame spacer (100), a plurality of the frame spacers (100) are disposed between the first frame beam (11) and the second frame beam (21), and additional of the frame spacers (100) are disposed on the inner side of the first frame beam (11) or the second frame beam (21).

The mounting bolt (230) simultaneously passes through the first display body mounting hole (220), the second display body mounting hole (240), and the spacer fixing holes (210) of additional of the frame spacers (100). The first frame beam (11), the second frame beam (21), and the frame spacers (100) disposed between the two beams are clamped between the mounting bolt (230) and the additional of the frame spacers (100).

Through the above connection relationship, the mounting bolt (230) and the additional of the frame spacers (100) can detachably assemble the first display body (10) and the second display body (20) together, while the frame spacers (100) are stacked between the first display body (10) and the second display body (20).

As shown in FIG. 11, in practice, a single frame spacer (100) may also be disposed between the first frame beam (11) and the second frame beam (21).

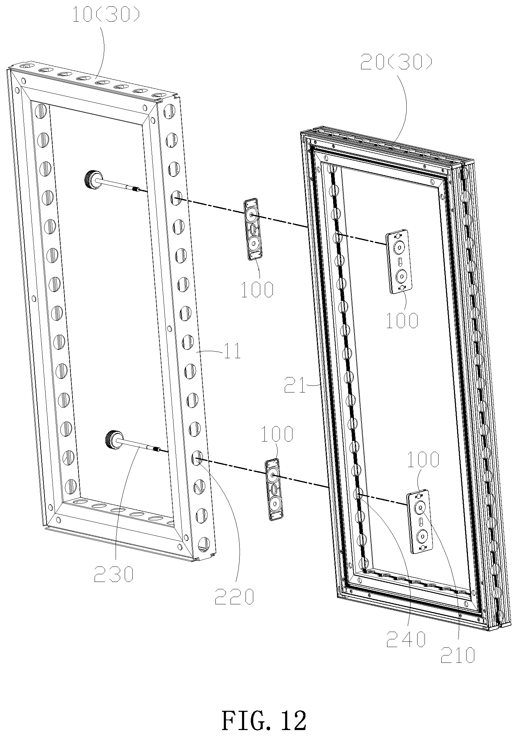

As shown in FIG. 12, the mounting bolt (230) may also simultaneously pass through the spacer fixing holes (210) of a plurality of the frame spacers (100) disposed between the first frame beam (11) and the second frame beam (21).

In a specific implementation, the spacer fixing hole (210) is a threaded hole, and the mounting bolt (230) is a threaded bolt.

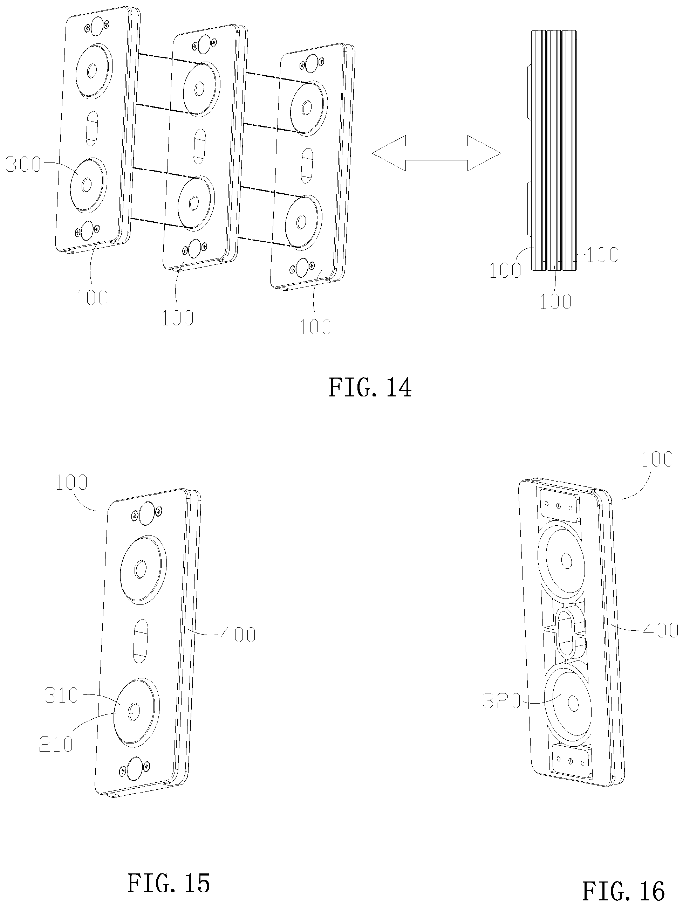

As shown in FIG. 14, in a specific implementation, the frame spacer (100) is provided with a spacer stacking structure (300), N of the frame spacers (100) can be stacked together via the spacer stacking structure (300), thereby facilitating the stacking of N of the frame spacers (100), as well as the storage, and transportation of the frame spacers (100).

As shown in FIGs. 15 and 16, the spacer stacking structure (300) comprises a protruding portion (310) and a recessed cavity (320), wherein the protruding portion (310) protrudes from one side of the frame spacer (100), and the recessed cavity (320) is recessed into the other side of the frame spacer (100).

When N of the frame spacers (100) are stacked together, the protruding portion (310) of one of the frame spacer (100) is inserted into the recessed cavity (320) of another of the frame spacer (100), such that the N of the frame spacers (100) can be stacked together.

In a specific implementation, the spacer fixing hole (210) is formed at the top of the protruding portion (310), and the spacer fixing hole (210) communicates with the recessed cavity (320).

In practice, the protruding portion (310) is cylindrical, the recessed cavity (320) is a cylindrical inner cavity, and the spacer fixing hole (210) is circular.

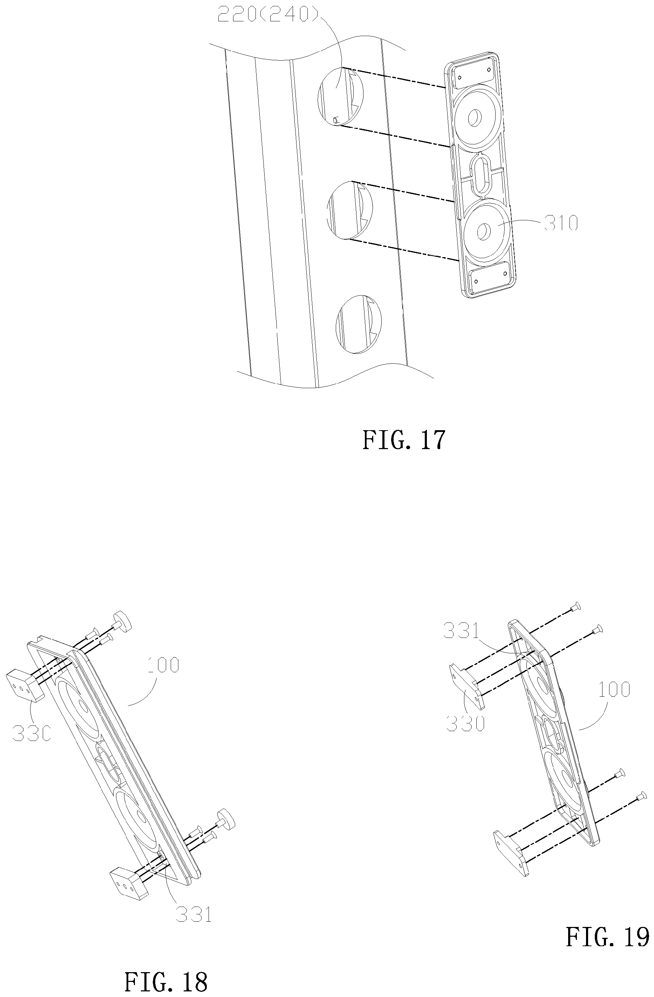

As shown in FIG. 17, in a specific implementation, the protruding portion (310) may be inserted into the first display body mounting hole (220) or the second display body mounting hole (240), so as to position the frame spacer (100) with respect to the first display body (10) or the second display body (20), thereby facilitating assembly.

As shown in FIGs. 18 and 19, in a specific implementation, the spacer stacking structure (300) further comprises a magnet (330), the magnet (330) is disposed on the frame spacer (100).

When N of the frame spacers (100) are stacked together, the magnet (330) of one of the frame spacer (100) is magnetically attracted to the magnet (330) of another of the frame spacer (100), thereby facilitating stacking of the N of the frame spacers (100).

When the frame spacer (100) is connected to the first display body (10), the magnet (330) is magnetically attracted to the first frame beam (11), thereby facilitating positioning of the frame spacer (100) relative to the first display body (10), and enabling convenient assembly and disassembly of the frame spacer (100).

In a specific implementation, the frame spacer (100) is provided with a magnet cavity (331), and the magnet (330) is disposed in the magnet cavity (331), in practice, the magnets (330) are respectively disposed at the upper and lower ends of the frame spacer (100).

As shown in FIGs. 15, 16, 20, and 21, in a specific implementation, the frame spacer (100) is provided with a cloth insertion slot (400). When the frame spacer (100) is connected to the first display body (10), an edge portion of the advertising cloth (31) can be inserted into the cloth insertion slot (400), thereby facilitating assembly and fixation of the advertising cloth (31).

When the frame spacer (100) is to be detached from the first display body (10), or when N of the frame spacers (100) stacked together are to be separated, the cloth insertion slot (400) facilitates detachment or separation. Specifically, a human finger can be inserted into the cloth insertion slot (400), thereby facilitating detachment or separation.

The cloth insertion slot (400) is provided on the sides of the frame spacer (100).

In a specific implementation, the frame spacer (100) is a rectangular cuboid, and the cloth insertion slots (400) are symmetrically provided on both sides of the frame spacer (100).

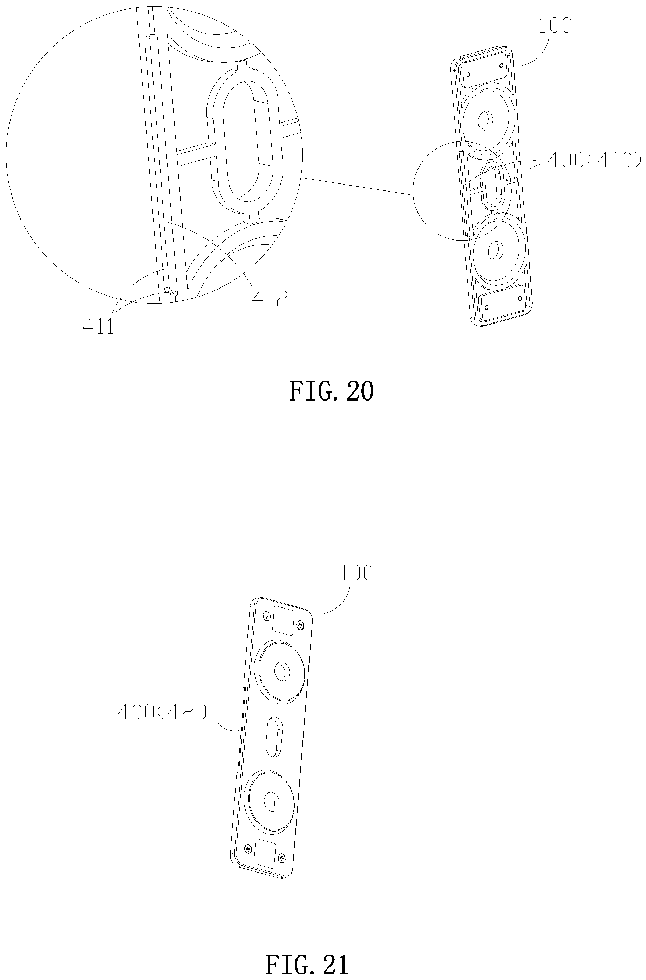

As shown in FIGs. 20 and 21, the following describes one embodiment of the cloth insertion slot (400), with specific details as follows: the cloth insertion slot (400) comprises a slot body (410) and an opening (420), wherein the opening (420) communicates with one side of the slot body (410), when the frame spacer (100) is connected to the first display body (10), the outer surface of the first frame beam (11) covers the opening (420), and the outer surface together with the side wall (411) and bottom surface (412) of the slot body (410) define the cloth insertion slot (400).

As shown in FIGs. 15, 16, and 18, the structure shown is a first preferred embodiment of the frame spacer (100), while as shown in FIGs. 19, 20, and 21, the structure shown is a second preferred embodiment of the frame spacer (100), wherein the frame spacer (100) of the two embodiments can be used individually or in combination.

In a specific implementation, the frame spacer (100) may also be configured in other structures, as described below.

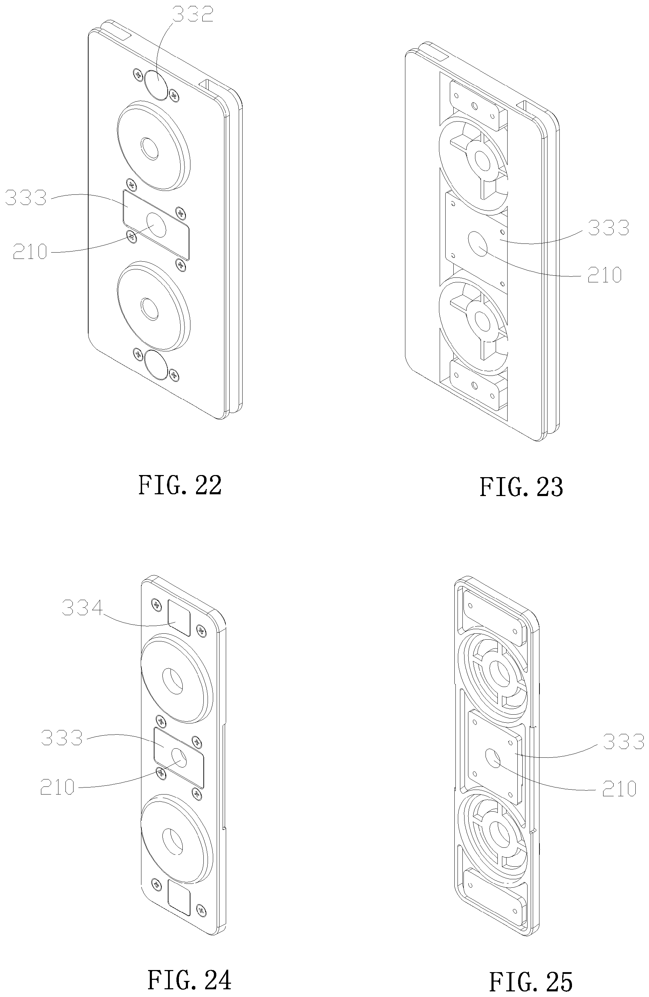

As shown in FIGs. 22 and 23, the structure shown is a third preferred embodiment of the frame spacer (100), wherein the spacer thickness dimension (T) is 8mm. The magnet (330) comprises a magnetic block (332) and a central iron plate (333), wherein the central iron plate (333) is also provided with the spacer fixing hole (210).

As shown in FIGs. 24 and 25, the structure shown is a fourth preferred embodiment of the frame spacer (100), wherein the spacer thickness dimension (T) is 4mm. The magnet (330) comprises an end iron plate (334) and a central iron plate (333), wherein the central iron plate (333) is also provided with the spacer fixing hole (210).

In the third and fourth preferred embodiments mentioned above, the central iron plate (333) corresponds to a magnetic block on the display frame (30) or the integrated LED display panel (40), so as to achieve magnetic positioning. The magnetic block (332) in the third preferred embodiment is magnetically attracted to the display frame (30) or the integrated LED display panel (40). The frame spacers (100) of the third and fourth preferred embodiments can be stacked together, such that the overall thickness of the spacers may be 12 millimeters, 16 millimeters, 20 millimeters, etc. Furthermore, when the frame spacers (100) of the third and fourth preferred embodiments are stacked together, the magnetic block (332) provides magnetic attraction between the spacers.

## Claims

1. A frame spacer (100) suitable for display frames, wherein said frame spacer (100) has a spacer thickness dimension (T), and N of said frame spacers (100) are detachably connected to a first display body (10), where N is greater than or equal to 1,
said first display body (10) has a first width dimension (W1) and a first height dimension (H1),
when N of said frame spacers (100) are disposed at the transverse position of said first display body (10), a transverse width dimension (WB1) of said first display body (10) is equal to the sum of said first width dimension (W1) and N times said spacer thickness dimension (T),
when N of said frame spacers (100) are disposed at the longitudinal position of said first display body (10), a longitudinal height dimension (HB1) of said first display body (10) is equal to the sum of said first height dimension (H1) and N times said spacer thickness dimension (T),
when N1 of said frame spacers (100) are disposed at the transverse position and N2 of said frame spacers (100) are disposed at the longitudinal position of said first display body (10), said transverse width dimension (WB1) of said first display body (10) is the sum of said first width dimension (W1) and N1 times said spacer thickness dimension (T), and said longitudinal height dimension (HB1) of said first display body (10) is the sum of said first height dimension (H1) and N2 times said spacer thickness dimension (T), wherein, the sum of N1 and N2 is equal to N,
a second display body (20) has a second width dimension (W2) and a second height dimension (H2),
when said second display body (20) is assembled together with said first display body (10), said second width dimension (W2) is equal to said transverse width dimension (WB1) of said first display body (10), and said second height dimension (H2) is equal to said longitudinal height dimension (HB1) of said first display body (10),
said first display body (10) is a display frame (30) or an integrated LED display panel (40), and said second display body (20) is said display frame (30) or said integrated LED display panel (40), wherein an advertising cloth (31) is disposed on said display frame (30) to display advertising information, and said integrated LED display panel (40) is used to display image information.

2. The frame spacer (100) suitable for display frames, as recited in claim 1, wherein said frame spacer (100) is provided with a frame connection structure (200),
through said frame connection structure (200), said frame spacer (100) can be detachably connected to said first display body (10),
through said frame connection structure (200), said first display body (10) and said second display body (20) can be assembled together via said frame spacer (100),
through said frame connection structure (200), said frame spacer (100) can be detachably connected to said first display body (10), and simultaneously, through said frame connection structure (200), said first display body (10) and said second display body (20) can be assembled together via said frame spacer (100).

3. The frame spacer (100) suitable for display frames, as recited in claim 1, wherein said frame spacer (100) is provided with a frame connection structure (200),
said frame connection structure (200) comprises spacer fixing holes (210) and mounting bolts (230), wherein said spacer fixing holes (210) are formed on said frame spacer (100),
corresponding to said spacer fixing holes (210), a plurality of first display body mounting holes (220) are provided around said first display body (10),
corresponding to said spacer fixing holes (210), a plurality of second display body mounting holes (240) are provided around said second display body (20),
said first display body (10) comprises a first frame beam (11), and said second display body (20) comprises a second frame beam (21), wherein said first display body mounting holes (220) are formed on said first frame beam (11), and said second display body mounting holes (240) are formed on said second frame beam (21).

4. The frame spacer (100) suitable for display frames, as recited in claim 3, wherein when said frame spacer (100) is detachably connected to said first display body (10) through said frame connection structure (200), said mounting bolt (230) passes through said spacer fixing hole (210) and said first display body mounting hole (220), said frame spacer (100) is detachably fixed to said first display body (10) by said mounting bolt (230);
when said first display body (10) and said second display body (20) are assembled together through said frame connection structure (200) by using said frame spacer (100), said mounting bolt (230) simultaneously passes through said first display body mounting hole (220), said second display body mounting hole (240), and said spacer fixing hole (210), such that said first frame beam (11) and said second frame beam (21) are clamped between said mounting bolt (230) and said frame spacer (100);
when said frame spacer (100) is detachably connected to said first display body (10) through said frame connection structure (200), and simultaneously, when said first display body (10) and said second display body (20) are assembled together through said frame connection structure (200) by using said frame spacer (100), a plurality of said frame spacers (100) are disposed between said first frame beam (11) and said second frame beam (21), and additional of said frame spacers (100) are disposed on the inner side of said first frame beam (11) or said second frame beam (21),
said mounting bolt (230) simultaneously passes through said first display body mounting hole (220), said second display body mounting hole (240), and said spacer fixing holes (210) of additional of said frame spacers (100), said first frame beam (11), said second frame beam (21), and said frame spacers (100) disposed between said two beams are clamped between said mounting bolt (230) and additional of said frame spacers (100).

5. The frame spacer (100) suitable for display frames, as recited in claim 4, wherein said spacer fixing hole (210) is a threaded hole, and said mounting bolt (230) is a threaded bolt.

6. The frame spacer (100) suitable for display frames, as recited in claim 1, wherein said frame spacer (100) is provided with a spacer stacking structure (300), N of said frame spacers (100) can be stacked together via said spacer stacking structure (300).

7. The frame spacer (100) suitable for display frames, as recited in claim 6, wherein said spacer stacking structure (300) comprises a protruding portion (310) and a recessed cavity (320), wherein said protruding portion (310) protrudes from one side of said frame spacer (100), and said recessed cavity (320) is recessed into the other side of said frame spacer (100).

8. The frame spacer (100) suitable for display frames, as recited in claim 1, wherein said frame spacer (100) is provided with a frame connection structure (200),
said frame connection structure (200) comprises spacer fixing holes (210) and mounting bolts (230), wherein said spacer fixing holes (210) are formed on said frame spacer (100),
corresponding to said spacer fixing holes (210), a plurality of first display body mounting holes (220) are provided around said first display body (10),
corresponding to said spacer fixing holes (210), a plurality of second display body mounting holes (240) are provided around said second display body (20),
said first display body (10) comprises a first frame beam (11), and said second display body (20) comprises a second frame beam (21), wherein said first display body mounting holes (220) are formed on said first frame beam (11), and said second display body mounting holes (240) are formed on said second frame beam (21),
said frame spacer (100) is provided with a spacer stacking structure (300), said spacer stacking structure (300) comprises a protruding portion (310) and a recessed cavity (320), wherein said protruding portion (310) protrudes from one side of said frame spacer (100), and said recessed cavity (320) is recessed into the other side of said frame spacer (100).

9. The frame spacer (100) suitable for display frames, as recited in claim 8, wherein said spacer fixing hole (210) is formed at the top of said protruding portion (310), and said spacer fixing hole (210) communicates with said recessed cavity (320).

10. The frame spacer (100) suitable for display frames, as recited in claim 9, wherein said protruding portion (310) is cylindrical, said recessed cavity (320) is a cylindrical inner cavity, and said spacer fixing hole (210) is circular.

11. The frame spacer (100) suitable for display frames, as recited in claim 8, wherein said spacer stacking structure (300) further comprises a magnet (330), said magnet (330) is disposed on said frame spacer (100),
when N of said frame spacers (100) are stacked together, said magnet (330) of one of said frame spacer (100) is magnetically attracted to said magnet (330) of another of said frame spacer (100),
when said frame spacer (100) is connected to said first display body (10), said magnet (330) is magnetically attracted to said first frame beam (11).

12. The frame spacer (100) suitable for display frames, as recited in claim 11, wherein said frame spacer (100) is provided with a magnet cavity (331), and said magnet (330) is disposed in said magnet cavity (331), said magnets (330) are respectively disposed at the upper and lower ends of said frame spacer (100).

13. The frame spacer (100) suitable for display frames, as recited in claim 8, wherein said frame spacer (100) is provided with a cloth insertion slot (400), when said frame spacer (100) is connected to said first display body (10), an edge portion of said advertising cloth (31) can be inserted into said cloth insertion slot (400).

14. The frame spacer (100) suitable for display frames, as recited in claim 13, wherein said cloth insertion slot (400) is provided on the sides of said frame spacer (100), said frame spacer (100) is a rectangular cuboid, and said cloth insertion slots (400) are symmetrically provided on both sides of said frame spacer (100).

15. The frame spacer (100) suitable for display frames, as recited in claim 13, wherein said cloth insertion slot (400) comprises a slot body (410) and an opening (420), wherein said opening (420) communicates with one side of said slot body (410), when said frame spacer (100) is connected to said first display body (10), outer surface of said first frame beam (11) covers said opening (420), and said outer surface together with side wall (411) and bottom surface (412) of said slot body (410) define said cloth insertion slot (400).
